# EUROPEAN PATENT APPLICATION

(11) **EP 4 741 766 A1**
(43) Date of publication of application: **13.05.2026**
(21) Application number: 25214053.8
(22) Date of filing: 06.11.2025
(51) Int. Cl.: G01C 19/62, G01R 33/26

(54) **LASER-BASED ATOMIC SENSOR SYSTEM COMPRISING A FABRY-PÉROT RESONATOR**

(30) Priority: 07.11.2024 DE 102024132477
(71) Applicant: Arda Atomics GmbH, 70173 Stuttgart (DE)
(72) Inventor: Torralbo-Campo, Lara, 71083 Herrenberg (DE); Padniuk, Mikhail, 70599 Stuttgart (DE); Konrad, Alexander, 71083 Herrenberg (DE)
(74) Representative: DREISS Patentanwälte PartG mbB

(57) **Abstract**

The present invention relates to an atomic sensor system (1) with a vapor cell (2) comprising an alkali metal vapor, a pump laser system (3) configured to generate an optical pump beam (4) along a first axis (5) through the vapor cell (2), a magnetic field system (6) configured to generate a magnetic field along the first axis (5) through the vapor cell (2) and a probe laser system (7) configured to generate an optical probe beam (8) along a second axis (9) through the vapor cell (2).

The present invention is based on the general idea that the atomic sensor system (1) comprises a Fabry-Pérot resonator (10), wherein the alkali metal vapor of the vapor cell (2) is located inside the Fabry-Pérot resonator (10).

## Description

The present invention relates to a laser-based atomic sensor system with a vapor cell comprising an alkali metal vapor. The invention also relates to a gyroscope system comprising such an atomic sensor system and/or to a system comprising this gyroscope system.

US2023273278A1 describes an atomic vapor cell, for atomic or molecular spectroscopy, optical pumping, and/or spin-based atomic sensing, that includes a host substrate and defined there within a buried or non-buried chamber laser written in the host substrate without the need of a mask or photoresist, with either planar or three-dimensional geometry, and intended to contain an atomic vapor.

The problem addressed by the present invention is to improve the measurement sensitivity with respect to the Faraday rotation of the optical probe beam, which is caused by the embedded atoms of the alkali metal vapour and the magnetic field.

This problem is solved according to the invention by the subject-matter of the independent claims. The dependent claims relate to advantageous embodiments.

The invention is based on the general idea that the alkali metal vapor is enclosed by an optical resonator. This optical resonator is a Fabry-Pérot resonator, in particular a Fabry-Pérot interferometer (FPI) and/or etalon. Thus, the atomic sensor system comprises a Fabry-Pérot resonator, wherein the alkali metal vapor of the vapor cell is located inside the Fabry-Pérot resonator. The probe beam emanating from the Fabry-Pérot resonator may be used to improve the measurement sensitivity of the laser-based atomic sensor system. As a result, magnetic field changes may be detected much more accurately and may form the basis for generating control signals of systems that comprise such an atomic sensor system according to the invention.

The laser-based atomic sensor system comprises a pump laser system configured to generate an optical pump beam, in particular an optical laser pump beam, along a first axis through the vapor cell, a magnetic field system configured to generate a magnetic field along the first axis through the vapor cell and a probe laser system configured to generate an optical probe beam, in particular an optical laser probe beam, along a second axis through the vapor cell. The first axis and the second axis may be perpendicular to one another.

In an advantageous embodiment, the Fabry-Pérot resonator comprises a first reflective surface and a second reflective surface, wherein the first reflective surface and the second reflective surface are spaced apart from each other with respect to the second axis. This provides an optimal system structure.

The pump laser system may be configured to generate the optical pump beam such that the optical pump beam propagates through the vapor cell but not through the first reflective surface and/or the second reflective surface of the Fabry-Pérot resonator. In other words, the optical pump beam propagates through the vapor cell between the first reflective surface and the second reflective surface of the Fabry-Pérot resonator.

The magnetic field system may be configured to generate the magnetic field such that the magnetic field permeates the vapor cell and/or the Fabry-Pérot resonator, in particular the first reflective surface and/or the second reflective surface of the Fabry-Pérot resonator.

The pump laser system may be configured to generate the optical probe beam such that the optical probe beam propagates through the vapor cell and through the first reflective surface and the second reflective surface of the Fabry-Pérot resonator.

In an advantageous embodiment, the first reflective surface and the second reflective surface are each planar and/or flat formed. Alternatively or additionally, the first reflective surface and the second reflective surface are spaced apart from each other by a distance, in particular by an invariable distance, with respect to the second axis. The distance between the first reflective surface and the second reflective surface may be greater than or equal to 10 mm. The distance between the first reflective surface and the second reflective surface may be greater than or equal to 15 mm. The distance between the first reflective surface and the second reflective surface may be greater than or equal to 20 mm.

The first reflective surface and the second reflective surface form two parallel reflective planar and/or flat surfaces, whereby the optical probe beam only propagates through the Fabry-Pérot cavity when it is in resonance with it. The invariable distance, in particular a constant and/or unchangeable distance, has the advantage of counteracting unwanted changes of the Fabry-Pérot cavity resonance.

**In** an advantageous embodiment, at least one reflective surface, in particular both reflective surfaces, of the Fabry-Pérot resonator is formed by a reflective coating of the vapor cell. This has the advantage that the vapor cell, which includes the Fabry-Pérot resonator, can be made very compact and production errors when using the Fabry-Pérot resonator are counteracted.

Alternatively or additionally, at least one reflective surface, in particular both reflective surfaces, of the Fabry-Pérot resonator is formed by a mirror, wherein this mirror is formed separately from the vapor cell. This has the advantage that the vapour cells that have been used or produced so far can be quickly and cost-effectively equipped with an additional Fabry-Pérot resonator.

In an advantageous embodiment, the vapor cell comprises a casing with a first section and a second section which are transparent and/or permeable, wherein the first reflective surface of the Fabry-Pérot resonator is formed by a reflective coating of the first section, wherein the second reflective surface of the Fabry-Pérot resonator is formed by a reflective coating of the second section. Alternatively or additionally, the first section comprises a first outer surface of the casing and a first inside surface of the casing, while the second section comprises a second inside surface of the casing and a second outer surface of the casing. This provides an efficient and compact construction.

In an advantageous embodiment, the first outer surface, the first inside surface, the second inside surface and the second outer surface are each formed planar. Alternatively or additionally, the first outer surface has a surface vector, said surface vector of the first outer surface being parallel to the second axis. Alternatively or additionally, the first inside surface has a surface vector, said to be the surface vector of the first inside surface being parallel to the second axis. Alternatively or additionally, the second inside surface has a surface vector, said to be the surface vector of the second inside surface being parallel to the second axis. Alternatively or additionally, the second outer surface has a surface vector, said surface vector of the second outer surface being parallel to the second axis

In an advantageous embodiment, the first reflective surface of the Fabry-Pérot resonator is formed by a reflective coating of the first outer surface, and/or the first reflective surface of the Fabry-Pérot resonator is formed by a reflective coating of the first inside surface.

Alternatively or additionally, the second reflective surface of the Fabry-Pérot resonator is formed by a reflective coating, in particular a dielectric reflective coating, of the second inside surface, and/or the second reflective surface of the Fabry-Pérot resonator is formed by a reflective coating, in particular a dielectric reflective coating, of the second outer surface.

In an advantageous embodiment, the Fabry-Pérot resonator comprises a free spectral range smaller than an absorption spectral range of the alkali vapor. Alternatively or additionally, the free spectral range of the Fabry-Pérot resonator is configured and/or formed by a distance between the first reflective surface and the second reflective surface. Alternatively or additionally, the free spectral range of the Fabry-Pérot resonator is configured and/or formed by a reflectivity of the first reflective surface and the second reflective surface.

The atomic sensor system comprises an optical detection system configured to measure the probe beam emanating from the vapor cell, wherein the pump laser system comprises a probe laser control unit configured to adjust optical frequency of the probe optical beam. In an advantageous embodiment the probe laser control unit is configured to scan the optical frequency of the probe optical beam over an optical frequency range in order to identify an optimal optical frequency based on the measurement by the optical detection system. The optimal optical frequency may be a frequency at which the derivation of the measured signal has a maximum or minimum. This maximizes the sensitivity of the probe beam emanating from the Fabry-Pérot resonator.

The probe laser control unit is configured to modulate the optical frequency of the probe optical beam of at least 1 MHz to perform a FM lock and/or phase lock.

In an advantageous embodiment, the probe laser control unit is configured to scan the optical frequency of the probe optical beam over several GHz, in particular several hundreds of GHz, to find the optimal optical frequency, and/or wherein the optimal optical frequency is a frequency at which the derivation of the measured signal has a maximum or minimum, and/or wherein the optimal optical frequency is a frequency between a minimum and a maximum of the alkali metal vapor absorption spectrum, and/or wherein the optimum optical frequency is a frequency at which the measurement of the probe beam by the optical detection system is more sensitive than at other optical frequencies.

In an advantageous embodiment, the atomic sensor system comprises a heating control system, in particular an external or internal temperature control system, configured to control the alkali-metal vapour density, and/or wherein the heating control system, in particular the temperature control system, comprises a feedback system that is configured to stabilize the temperature of the alkali metal vapour.

In an advantageous embodiment according to any one of the preceding embodiments, the atomic sensor system is configured such that the alkali metal vapor is enclosed by the optical resonator with a Free Spectral Range (FSR) smaller than the spectral linewidth and/or frequency width of the optical probe beam entering the vapor cell.

In an advantageous embodiment according to any one of the preceding embodiments, the atomic sensor system is configured to measure the probe beam emanating from emanating from the Fabry-Pérot resonator, wherein the atomic sensor system is configured to lock the laser wavelength of the optical pump beam by the atomic sensor system to the side of fringe of the cavity transmission by frequency modulation spectroscopy or a phase lock. The side of the fringe of the cavity transmission may be the frequency at which the derivation of the measured signal has a maximum or minimum. The atomic sensor system may be configured to demodulate the measured signal based on the probe beam emanated from the Fabry-Pérot resonator.

In an advantageous embodiment according to any one of the preceding embodiments, the atomic sensor system is configured to stabilize the temperature of the atomic vapour cell by the DC amplitude of the demodulated laser probe beam emanated from the Fabry-Pérot resonator prior locked to the side of fringe by the atomic sensor system, and/or the atomic sensor system is configured to detect the faraday rotation by detecting the intensity modulated transmission signal of the laser probe beam emanated from the Fabry-Pérot resonator.

In an advantageous embodiment according to any one of the preceding embodiments, the FSR of the optical resonator is by the distance between first reflective surface and the second reflective surface of the Fabry-Pérot resonator, wherein the Finesse is provided by the reflectivity of the surface, in particular the surfaces, of the Fabry-Pérot resonator, in particular of the first reflective surface and/or the second reflective surface. The Fabry-Pérot resonator may be configured to fulfill the required FSR and Finesse.

The reflectivity of the surface for a specific wavelength may be achieved by reflective coatings for the specific wavelength can be achieved by tailoring the thickness of dielectric layers of alternating substrates such as SiO2, TiO2, Al2O3, Ta2O5, MgF2, LaF3 and/or AIF3.

In an advantageous embodiment according to any one of the preceding embodiments, for an absorption spectrum with a width of 10 GHz, the FSR with 5 GHz is achieved by a cavity of around 20mm. The FSR, which is the frequency separation of two transmission maxima, is given by *Δυ=c*/*2nL* and depends only on the refractive index and the length. For a sensitive frequency discrimination a Finesse larger than 10 may be realized by reflectivities of the coatings of above 80%. The Finesse as a measure for the sensitivity of the frequency-to-transmission amplitude may be determined by the reflectivity of the mirrors of the Fabry-Pérot resonator.

In an advantageous embodiment according to any one of the preceding embodiments, the coated vapour cell with Rubidium and an integrated heater is put in a controlled magnet environment. A tunable laser light with a wavelength matching to the absorption wavelength of an atomic transition is coupled into the cell and a photodiode is setup to detect the transmitted signal. The laser light may be scanned over several hundreds of GHz to find the absorption signal and may be modulated above 1 MHz to perform a FM lock. The temperature of the cell may be set by a control signal to an integrated heater. A photodetector may be connected to a fast analog-to-digital converter or oscilloscope. The fast-locking of the laser may be done by an FPGA or comparable electronics. The slow lock of the temperature control signal may be done by a digital-to-analog converter or a signal generator by a computer. The atomic sensor system described above or below may include any of the components described above or below, either individually or in combination with other components.

Furthermore, the invention relates to a gyroscope system comprising at least one atomic sensor system according to the invention, which is described above and/or below. The atomic sensor system may be used to determine an orientation of the gyroscope system.

Furthermore, the invention relates to a satellite, and/or a vehicle, in particular a ground, land, sea and/or air vehicle, and/or a spacecraft comprising at least one gyroscope system according to the invention, which is described above and/or below. The gyroscope system may be used to determine an orientation of the gyroscope system of the device comprising this gyroscope system. The vehicle may be an autonomous vehicle.

Further important features and advantages of the disclosure result from the dependent claims, from the drawings and from the associated description of the figures with reference to the drawings.

It goes without saying that the features mentioned above and those still to be explained in the following can be used not only in the respective specified combination, but also in other combinations or on their own, without departing from the scope of the present disclosure.

Preferred embodiments of the invention are shown in the drawings and are explained in more detail in the following description, whereby identical reference numerals refer to identical or similar or functionally identical components.

The disclosure will now be described with reference to the drawings wherein:
- Fig. 1: shows an atomic sensor system with a vapor cell according to the invention,
- Fig. 2: shows a casing of the vapor cell comprising an Fabry-Pérot resonator,
- Fig. 3: shows, besides other things, a measured signal from the optical detection system as function of the optical frequency of the probe laser.

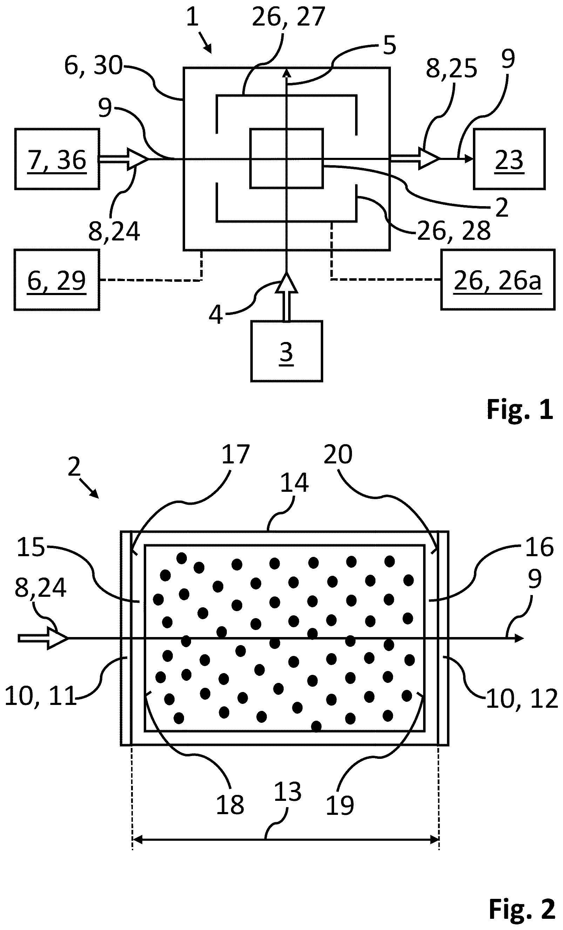

The Fig. 1 shows an atomic sensor system 1 according to the invention comprising at least one vapor cell 2 filled with an alkali metal vapor. The atomic sensor system 1 comprises a magnetic field system 6 configured to generate a magnetic field along a first axis 5 through the vapor cell 2. This magnetic field system 6 may comprise a magnetic field control unit 29 and a system of magnetic field coils 30, wherein the magnetic field control unit 29 may be configured in such a way that the magnetic field coils 30 generate the required magnetic fields, in particular along a first axis 5 through the vapor cell 2.

In addition, the atomic sensor system 1 comprises heating control system 26, in particular an external or internal temperature control system, configured to control the alkali-metal vapour density. The heating control system 26 comprises a heating unit 27, 28 with a heating control unit 26a. The heating control system 26 may have a first part 27 of the heating unit and a second part 28 of the heating unit. The vapor cell 2 may be placed inside and/or between the heating units 27, 28 and the heating control unit 26a may be configured in such a way that the concentration of the alkali-metal atoms inside the vapor cell 2 is steered with the temperature of the vapor cell 2. The heating control system 26, in particular the temperature control system, may comprise a feedback system that is configured to stabilize the temperature of the alkali metal vapour. The heating unit 26, 27 and the vapor cell 2 may be placed inside the magnetic field system 6 and/or between the magnetic field coils 30 of the magnetic field system 6.

A pump laser system 3 of the atomic sensor system 1 is configured to generate an optical pump beam 4 along a first axis 5 through the vapor cell 2, while a probe laser system 7 is configured to generate an optical probe beam 8 along a second axis 9 through the vapor cell 2. The first axis 5 and the second axis 9 are perpendicular to each other. The pump laser system 3 comprises a probe laser control unit 36 which is configured to adjust optical frequency of the probe optical beam 8, 24 entering the vapor cell, in particular the probe laser control unit 36 may be configured to scan the optical frequency of the probe optical beam 8 over an optical frequency range in order to identify an optimal optical frequency 35 based on the measurement by an optical detection system 23 which is configured to measure the probe beam 8, 25 emanating from the vapor cell 2.

As shown in the Fig. 2, the atomic sensor system 1 comprises a Fabry-Pérot resonator 10, wherein the alkali metal vapor of the vapor cell 2 is located inside the Fabry-Pérot resonator 10. The Fabry-Pérot resonator 10 comprises a first reflective surface 11 and a second reflective surface 12, wherein the first reflective surface 11 and the second reflective surface 12 are spaced apart from each other with respect to the second axis 9. The distance between the first reflective surface 11 and the second reflective surface 12 may be greater than or equal to 10 mm. The first reflective surface 11 and the second reflective surface 12 are each planar and/or flat formed and the first reflective surface 11 and the second reflective surface 12 are spaced apart from each other by a distance 13, in particular by an invariable distance 13, with respect to the second axis 9. The distance between the first reflective surface 11 and the second reflective surface 12 may be greater than or equal to 15 mm. The distance between the first reflective surface 11 and the second reflective surface 12 may be greater than or equal to 20 mm. At least one reflective surface 11, 12 of the Fabry-Pérot resonator 10 is formed by a reflective coating of the vapor cell 2, and/or at least one reflective surface 11, 12 of the Fabry-Pérot resonator 10 is formed by a mirror, wherein this mirror is formed separately from the vapor cell 2.

The vapor cell 2 comprises a casing 14 with a first section 15 and a second section 16 which are transparent and/or permeable, wherein the first reflective surface 11 of the Fabry-Pérot resonator 10 is formed by a reflective coating of the first section 15, wherein the second reflective surface 12 of the Fabry-Pérot resonator 10 is formed by a reflective coating of the second section 16. The first section 15 comprises a first outer surface 17 of the casing 14 and a first inside surface 18 of the casing 14, while the second section 16 comprises a second inside surface 19 of the casing 14 and a second outer surface 20 of the casing 14. The first outer surface 17, the first inside surface 18, the second inside surface 19 and the second outer surface 20 may each be formed planar.

The first reflective surface 11 of the Fabry-Pérot resonator 10 is formed by a reflective coating of the first outer surface 17, and/or the first reflective surface 11 of the Fabry-Pérot resonator 10 is formed by a reflective coating of the first inside surface 18. The second reflective surface 12 of the Fabry-Pérot resonator 10 is formed by a reflective coating, in particular a dielectric reflective coating, of the second inside surface 19, and/or the second reflective surface 12 of the Fabry-Pérot resonator 10 is formed by a reflective coating, in particular a dielectric reflective coating, of the second outer surface 20.

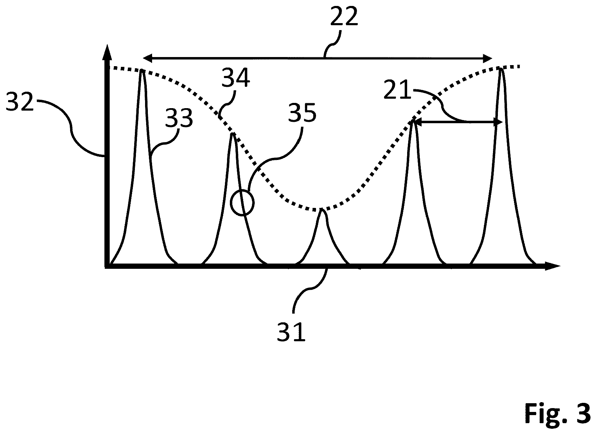

The Fig. 3 shows a plot, wherein one axis relates the value 32 of the signal from the optical detection system 23 and the other axis relates the value 31 of the optical frequency of the probe laser. Moreover, the Fig. 3 shows a measured signal 33 from the optical detection system 23 and an alkali metal vapor absorption spectrum in the case without Fabry-Pérot resonator 10.

As shown in Fig. 3, the Fabry-Pérot resonator 10 comprises a Free Spectral Range 21 smaller than an absorption spectral range 22 of the alkali vapor, wherein the free spectral range 21 of the Fabry-Pérot resonator 10 is configured and/or formed by the distance 13 between the first reflective surface 11 and the second reflective surface 12, and/or wherein the free spectral range 21 of the Fabry-Pérot resonator 10 is configured and/or formed by a reflectivity of the first reflective surface 11 and the second reflective surface 12.

The probe laser control unit 36 is configured to scan the optical frequency of the probe optical beam 8 over several GHz, in particular several hundreds of GHz, to find the optimal optical frequency 35, and/or wherein the probe laser control unit 36 is configured to modulate the optical frequency of the probe optical beam 8 of at least 1 MHz to perform a FM lock and/or phase lock. The optimal optical frequency 35 is a frequency at which the derivation of the measured signal 33 has a maximum or minimum, and wherein the optimal optical frequency 35 is a frequency between a minimum and a maximum of the alkali metal vapor absorption spectrum 34. Thus, the optimum optical frequency 35 is a frequency at which the measurement of the probe beam 8, 25 by the optical detection system 23 is more sensitive than at other optical frequencies.

### References

- 1: atomic sensor system
- 2: vapor cell
- 3: pump laser system
- 4: optical pump beam
- 5: first axis
- 6: magnetic field system
- 7: probe laser system
- 8: optical probe beam
- 9: second axis
- 10: Fabry-Pérot resonator
- 11: first reflective surface
- 12: second reflective surface
- 13: unchangeable/invariable distance
- 14: casing
- 15: first section
- 16: second section
- 17: first outer surface of the casing
- 18: first inside surface of the casing
- 19: second inside surface of the casing
- 20: second outer surface of the casing
- 21: free spectral range
- 22: absorption spectral range
- 23: optical detection system, in particular an optical polarization detection system
- 24: probe beam entering the vapor cell
- 25: probe beam exiting the vapor cell
- 26: heating control system
- 27: first part of the heating unit
- 28: second part of the heating unit
- 29: magnetic field control unit
- 30: system of magnetic field coils
- 31: optical frequency of the probe laser
- 32: value of the signal from the optical detection system
- 33: measured signal from the optical detection system
- 34: alkali metal vapor absorption spectrum in the case without Fabry-Pérot resonator
- 35: optimal optical frequency of the probe laser
- 36: probe laser control unit

## Claims

1. An atomic sensor system (1) comprising:
- a vapor cell (2) comprising an alkali metal vapor;
- a pump laser system (3) configured to generate an optical pump beam (4) along a first axis (5) through the vapor cell (2);
- a magnetic field system (6) configured to generate a magnetic field along the first axis (5) through the vapor cell (2);
- a probe laser system (7) configured to generate an optical probe beam (8) along a second axis (9) through the vapor cell (2);
**characterized in that**
- the atomic sensor system (1) comprises a Fabry-Pérot resonator (10), wherein the alkali metal vapor of the vapor cell (2) is located inside the Fabry-Pérot resonator (10), wherein the atomic sensor system (1) comprises an optical detection system (23) configured to measure the probe beam (8, 25) emanating from the vapor cell (2), wherein the pump laser system (3) comprises a probe laser control unit (36) configured to adjust optical frequency of the probe optical beam (8), wherein the probe laser control unit (36) is configured to modulate the optical frequency of the probe optical beam (8) of at least 1 MHz to perform a FM lock and/or phase lock.

2. The atomic sensor system (1) according to claim 1,
**characterized in that**
- the Fabry-Pérot resonator (10) comprises a first reflective surface (11) and a second reflective surface (12),
- wherein the first reflective surface (11) and the second reflective surface (12) are spaced apart from each other with respect to the second axis (9).

3. The atomic sensor system (1) according to claim 2,
**characterized in that**
- the first reflective surface (11) and the second reflective surface (12) are each planar and/or flat formed, and/or
- wherein the first reflective surface (11) and the second reflective surface (12) are spaced apart from each other by a distance (13), in particular by an invariable distance (13), with respect to the second axis (9).

4. The atomic sensor system (1) according to claim 2 or 3,
**characterized in that**
- at least one reflective surface (11, 12) of the Fabry-Pérot resonator (10) is formed by a reflective coating of the vapor cell (2), and/or
- at least one reflective surface (11, 12) of the Fabry-Pérot resonator (10) is formed by a mirror, wherein this mirror is formed separately from the vapor cell (2).

5. The atomic sensor system (1) according to any of claims 2 to 4,
**characterized in that**
- the vapor cell (2) comprises a casing (14) with a first section (15) and a second section (16) which are transparent and/or permeable,
- wherein the first reflective surface (11) of the Fabry-Pérot resonator (10) is formed by a reflective coating of the first section (15),
- wherein the second reflective surface (12) of the Fabry-Pérot resonator (10) is formed by a reflective coating of the second section (16).

6. The atomic sensor system (1) according to claim 5,
**characterized in that**
the first section (15) comprises a first outer surface (17) of the casing (14) and a first inside surface (18) of the casing (14), while the second section (16) comprises a second inside surface (19) of the casing (14) and a second outer surface (20) of the casing (14).

7. The atomic sensor system (1) according to claim 6,
**characterized in that**
- the first outer surface (17), the first inside surface (18), the second inside surface (19) and the second outer surface (20) are each formed planar, and/or
- wherein the first outer surface (17) has a surface vector, said surface vector of the first outer surface (17) being parallel to the second axis (9), and/or
- wherein the first inside surface (18) has a surface vector, said surface vector of the first inside surface (18) being parallel to the second axis (9), and/or
- wherein the second inside surface (19) has a surface vector, said surface vector of the second inside surface (19) being parallel to the second axis (9), and/or
- wherein the second outer surface (20) has a surface vector, said surface vector of the second outer surface (20) being parallel to the second axis (9).

8. The atomic sensor system (1) according to claim 6 or 7,
**characterized in that**
- the first reflective surface (11) of the Fabry-Pérot resonator (10) is formed by a reflective coating of the first outer surface (17), and/or
- the first reflective surface (11) of the Fabry-Pérot resonator (10) is formed by a reflective coating of the first inside surface (18).

9. The atomic sensor system (1) according to any of claims 6 to 8,
**characterized in that**
- the second reflective surface (12) of the Fabry-Pérot resonator (10) is formed by a reflective coating, in particular a dielectric reflective coating, of the second inside surface (19), and/or
- the second reflective surface (12) of the Fabry-Pérot resonator (10) is formed by a reflective coating, in particular a dielectric reflective coating, of the second outer surface (20).

10. The atomic sensor system (1) according to any one of the preceding claims, **characterized in that**
- the Fabry-Pérot resonator (10) comprises a free spectral range (21) smaller than an absorption spectral range (22) of the alkali vapor, and/or
- wherein the free spectral range (21) of the Fabry-Pérot resonator (10) is configured and/or formed by a distance (13) between the first reflective surface (11) and the second reflective surface (12), and/or
- wherein the free spectral range (21) of the Fabry-Pérot resonator (10) is configured and/or formed by a reflectivity of the first reflective surface (11) and the second reflective surface (12).

11. The atomic sensor system (1) according to any one of the preceding claims, **characterized in that**
- the probe laser control unit (36) is configured to scan the optical frequency of the probe optical beam (8) over an optical frequency range in order to identify an optimal optical frequency (35) based on the measurement by the optical detection system (23).

12. The atomic sensor system (1) according to claim 11,
**characterized in that**
- the probe laser control unit (36) is configured to scan the optical frequency of the probe optical beam (8) over several GHz, in particular several hundreds of GHz, to find the optimal optical frequency (35), and/or
- wherein the optimal optical frequency (35) is a frequency at which the derivation of the measured signal (33) has a maximum or minimum, and/or
- wherein the optimal optical frequency (35) is a frequency between a minimum and a maximum of the alkali metal vapor absorption spectrum (34), and/or
- wherein the optimum optical frequency (35) is a frequency at which the measurement of the probe beam (8, 25) by the optical detection system (23) is more sensitive than at other optical frequencies.

13. The atomic sensor system (1) according to any one of the preceding claims, **characterized in that**
- the atomic sensor system (1) comprises a heating control system (26), in particular an external or internal temperature control system, configured to control the alkali-metal vapour density, and/or
- wherein the heating control system (26), in particular the temperature control system, comprises a feedback system that is configured to stabilize the temperature of the alkali metal vapour.

14. A gyroscope system comprising at least one atomic sensor system (1) according to any one of the preceding claims in order to determine an orientation of the gyroscope system.

15. A satellite, and/or a vehicle, in particular a ground, land, sea and/or air vehicle, and/or a spacecraft comprising at least one gyroscope system according to claim 14 in order to determine an orientation of the device comprising this gyroscope system.
